# DEMANDE DE BREVET EUROPEEN

(11) **EP 4 095 960 A1**
(43) Date de publication de la demande: **30.11.2022**
(21) Numéro de dépôt: 22175199.3
(22) Date de dépôt: 24.05.2022
(51) Int. Cl.: H01M 8/04537, G01R 1/067, H01M 8/2483, G01R 31/396, G01R 19/00

(54) **DISPOSITIF DE MESURE DE LA TENSION D'UNE OU DE PLUSIEURS CELLULE(S) ÉLECTROCHIMIQUE(S)**

(30) Priorité: 26.05.2021 FR 2105460
(71) Demandeur: Alstom Hydrogène SAS, 13547 Aix en Provence Cedex 4 (FR)
(72) Inventeur: GUENOT, Benoit, 13100 AIX EN PROVENCE (FR); RAKOTONDRAINIBE, André, 13090 AIX-EN-PROVENCE (FR)
(74) Mandataire: Lavoix

(57) **Abrégé**

Le dispositif de mesure de tension est prévu pour la réalisation de mesures de tension sur un ensemble stratifié (22) formé de séparateurs (6) et d'au moins un assemblage membrane-électrodes (8) empilés pour former une ou plusieurs cellule(s) électrochimique(s) (10). Il comprend deux plaques de mesure (24) sur lesquelles sont répartis une pluralité de contacts électriques (28) espacés les uns des autres et isolés électriquement les uns des autres, les plaques de mesure (24) étant configurées pour être disposées de part et d'autre de l'ensemble stratifié (22), la face de mesure de chaque plaque de mesure (24) étant appliquée contre un séparateur (6) respectif de telle sorte que les contacts électriques (28) situés sur cette face de mesure (24A) sont en contact avec ledit séparateur (6).

## Description

La présente invention concerne le domaine des réacteurs électrochimiques comprenant un empilement formé de séparateurs et d'assemblages membrane-électrodes empilés suivant une direction d'empilement et définissant une ou plusieurs cellules électrochimiques.

Un tel réacteur électrochimique est par exemple une pile à combustible pour la production d'électricité par réaction électrochimique entre un comburant et un combustible, ou un électrolyseur pour la séparation d'éléments chimiques d'un fluide en utilisant de l'électricité, par exemple pour la production de dihydrogène et de dioxygène à partir d'eau.

Dans un tel réacteur électrochimique, chaque assemblage membrane-électrodes se présente sous la forme d'un stratifié comprenant une membrane échangeuse d'ions insérée entre deux électrodes.

Chaque séparateur est conducteur d'électricité et se présente sous la forme d'une plaque, une ou chacune des deux faces du séparateur étant configurée pour être appliquée contre une face d'un assemblage membrane-électrodes en définissant avec cette face de l'assemblage membrane-électrode une chambre fluidique pour la circulation d'un fluide le long de ladite face de l'assemblage membrane-électrodes.

Dans l'empilement, chaque cellule électrochimique est définie par un assemblage membrane-électrodes compris entre deux séparateurs, chacun des séparateurs définissant une chambre fluidique avec la face de l'assemblage membrane-électrodes contre laquelle il est appliqué, la réaction électrochimique étant réalisée par échange d'ions entre des fluides circulant dans les chambres fluidiques, au travers de l'assemblage membrane-électrodes.

Les cellules électrochimiques sont reliées électriquement en série. Les séparateurs assurent la conduction du courant électrique entre les cellules électrochimiques et la distribution des fluides dans les cellules électrochimiques.

L'empilement est généralement maintenu en compression mécanique type filtre-presse suivant la direction d'empilement afin d'obtenir une bonne étanchéité aux fluides entre les séparateurs et les assemblages membrane-électrodes, d'assurer un bon contact électrique entre les différents éléments (séparateurs et assemblages membrane-électrodes) et une réaction électrochimique efficace.

Il est souhaitable d'améliorer et de fiabiliser la performance électrochimique et la durabilité des réacteurs électrochimiques formés par l'empilement de séparateurs et d'assemblages membrane-électrodes.

La performance électrochimique d'un tel réacteur électrochimique dépend de plusieurs facteurs, en particulier de la nature et des caractéristiques physico-chimiques, thermiques et mécaniques des matériaux constituants chaque assemblage membrane-électrodes, de la conception et de la géométrie des séparateurs qui permettent à la fois la distribution des fluides et la conduction de courant électrique, de l'état de compression mécanique de l'empilement, et des conditions opératoires, notamment la température, la pression et le débit de chacun des fluides circulant dans les cellules électrochimiques.

La performance électrochimique d'une cellule électrochimique est notamment définie par sa courbe de polarisation reliant la réponse en tension avec le courant (i.e. reliant la tension électrique entre les deux séparateurs de la cellule électrochimique en fonction du courant électrique traversant la cellule électrochimique), et donc la puissance électrique associée en fonction des conditions opératoires.

La mesure de la tension d'une ou plusieurs cellule(s) électrochimique(s) d'un empilement est réalisée par exemple à l'aide de contacts électriques mis en contact avec les séparateurs dans des zones de contact prévues à cet effet sur les séparateurs, la zone de contact de chaque séparateur étant située à un endroit localisé du séparateur accessible une fois l'empilement réalisé, par exemple sur un bord périphérique du séparateur.

Cependant, la mesure de la tension d'une cellule électrochimique réalisée à partir d'une zone de contact localisée sur chacun des deux séparateurs de cette cellule électrochimique peut dépendre de la localisation des zones de contact sur les séparateurs à savoir en périphérie des séparateurs, c'est-à-dire sur les faces des séparateurs perpendiculaires au plan de l'assemblage membrane-électrodes, ou sur les faces des séparateurs parallèles au plan de l'assemblage membrane-électrodes. Une localisation différente des zones de contact sur les séparateurs peut donner un résultat différent.

C'est en particulier le cas pour des séparateurs réalisés par thermocompression d'un matériau composite composé de poudre de graphite et/ou de carbone noyée dans une matrice contenant un liant polymère et/ou une résine. De tels séparateurs peuvent en effet présenter une conductivité électrique anisotrope.

Un des buts de l'invention est de proposer un dispositif de mesure de tension permettant de réaliser une mesure fiable de la tension d'une cellule électrochimique ou de plusieurs cellules électrochimiques superposées résultant de l'empilement de séparateurs et d'un ou plusieurs assemblage(s) membrane-électrodes.

A cet effet, l'invention propose un dispositif de mesure de tension pour la réalisation de mesures de tension sur un ensemble stratifié formé de séparateurs et d'au moins un assemblage membrane-électrodes empilés suivant une direction de stratification pour former une cellule électrochimique ou plusieurs cellules électrochimiques superposées, un séparateur étant situé à chaque extrémité de l'ensemble stratifié, le dispositif de mesure de tension comprenant deux plaques de mesure, chaque plaque de mesure possédant une face de mesure sur laquelle sont répartis une pluralité de contacts électriques espacés les uns des autres et isolés électriquement les uns des autres, les plaques de mesure étant configurées pour être disposées de part et d'autre de l'ensemble stratifié, la face de mesure de chaque plaque de mesure étant appliquée contre un séparateur respectif parmi les deux séparateurs situés aux extrémités de l'ensemble stratifié, de telle sorte que les contacts électriques situés sur cette face de mesure sont en contact avec ledit séparateur.

Les plaques de mesure peuvent être disposées de part et d'autre de l'ensemble stratifié formé par superposition de séparateurs et d'un ou plusieurs assemblage(s) membrane-électrodes, la face de mesure de chacune des deux plaques de mesure étant en contact avec une face d'un séparateur respectif.

Les plaques de mesure peuvent notamment être insérées dans un empilement de séparateurs et d'assemblages membrane-électrode d'un réacteur électrochimique, pour mesurer la tension de l'ensemble stratifié formé de la ou des cellule(s) électrochimique(s) du réacteur électrochimique située(s) entre les deux plaques de mesure.

Les contacts électriques répartis sur la face de mesure de chacune des deux plaques de mesure permettent de réaliser des mesures de tension en différent points de mesure répartis sur les séparateurs, et ainsi de tenir compte d'une disparité de tension électrique entre les différents points de mesure définis par les différents contacts électriques.

Il est possible d'établir une cartographie indiquant la réponse en tension de chaque cellule électrochimique en fonction de la position dans un plan d'extension de la cellule électrochimique parallèle aux séparateurs et à l'assemblage membrane-électrode de cette cellule électrochimique.

Selon des modes de réalisation particulier, le dispositif de mesure de tension comprend une ou plusieurs des caractéristiques optionnelles suivantes, prise individuellement ou selon toutes les combinaisons techniquement possibles :
- chaque plaque de mesure possède un connecteur situé sur un bord de la plaque, chaque contact électrique porté par la plaque étant relié au connecteur ;
- le connecteur de chaque plaque de mesure comprend une pluralité de fiches, chaque fiche étant reliée électriquement à un contact électrique respectif parmi les contacts électriques de la plaque de mesure ;
- les contacts électriques sont répartis sur la face de mesure de chaque plaque de mesure de telle manière que chaque contact électrique d'une plaque de mesure soit en regard d'un contact électrique respectif de l'autre plaque de mesure lorsque les faces de mesure des plaques de mesure sont disposées en regard l'une de l'autre.
- chaque plaque de mesure comprend un substrat en forme de plaque réalisé dans un matériau électriquement isolant et portant les contacts électriques ;
- les contacts électriques de chaque plaque de mesure sont répartis dans une zone de la face de mesure correspondant à la surface active de la ou des cellule(s) électrochimique(s) de l'ensemble stratifié ;
- les contacts électriques de chaque plaque de mesure sont répartis sur la face de mesure de la plaque de mesure suivant une répartition matricielle, en lignes et en colonnes ;
- il comprend un appareil de mesure de tension multivoies configuré des déterminer des mesures de tension, une mesure de tension étant réalisée pour chaque point de mesure défini par un contact électrique d'une des plaques de mesure et un contact électrique associé de l'autre plaque de mesure situés sensiblement en regard l'un de l'autre ;
- chaque plaque de mesure comprend des fenêtres disposées de telle manière à être alignées avec des lumières d'un séparateur contre lequel la plaque de mesure est appliquée, prévues pour l'écoulement de fluides réactifs ou d'un fluide de refroidissement à travers le séparateur, chaque fenêtre de chaque plaque de mesure étant alignée avec une lumière respective du séparateur.

L'invention concerne aussi un ensemble comprenant ensemble stratifié formé de séparateurs et d'au moins un assemblage membrane-électrodes empilés suivant une direction de stratification pour former une cellule électrochimique ou plusieurs cellules électrochimiques superposées, un séparateur étant situé à chaque extrémité de l'ensemble stratifié, et un dispositif de mesure de tension tel que défini ci-dessus dont les plaques de mesure sont disposées de part et d'autre de l'ensemble stratifié, la face de mesure de chaque plaque de mesure étant appliquée contre un séparateur respectif parmi les deux séparateurs situés aux extrémités de l'ensemble stratifié, de telle sorte que les contacts électriques situés sur cette face de mesure sont en contact avec ledit séparateur.

Dans un mode de réalisation particulier, l'ensemble comprend un réacteur électrochimique comprenant un empilement formé de séparateurs et d'assemblages membrane-électrodes empilés définissant des cellules électrochimiques superposées, les plaques de mesure étant intégrées dans l'empilement, de part et d'autre d'un ensemble stratifié formé par des séparateurs et au moins un assemblage membrane-électrodes de l'empilement formant une ou plusieurs cellules électrochimiques de l'empilement.

L'invention et ses avantages seront mieux compris à la lecture de la description qui va suivre, donnée uniquement à titre d'exemple non limitatif, et faite en référence aux dessins annexés, sur lesquels :
- la Figure 1 est une vue de côté d'un réacteur électrochimique formé d'un empilement de séparateurs et d'assemblages membrane-électrodes, le réacteur électrochimique étant équipé d'un dispositif de mesure de tension ;
- la Figure 2 est une vue en coupe d'une cellule électrochimique, des plaques de mesure du dispositif de mesure de tension étant disposées de part et d'autre de la cellule électrochimique ;
- la Figure 3 est une vue en perspective de la cellule électrochimique et des plaques de mesure du dispositif de mesure de la Figure 2 ;

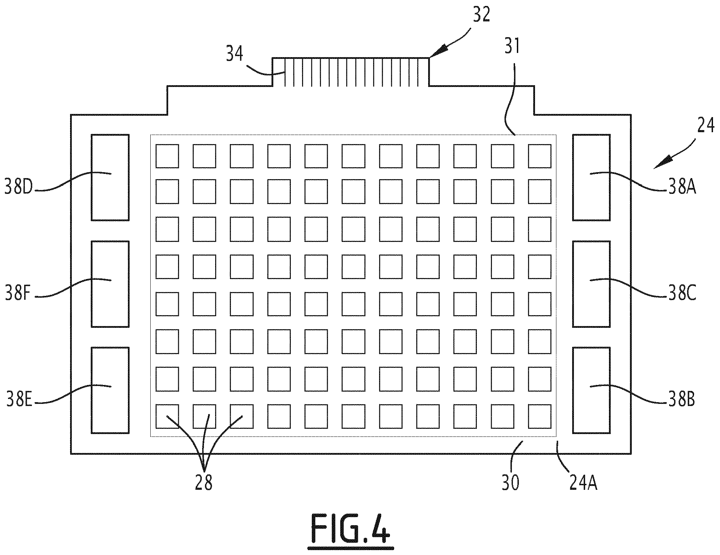

- la Figure 4 est une vue de face d'une plaque de mesure du dispositif de mesure de tension.

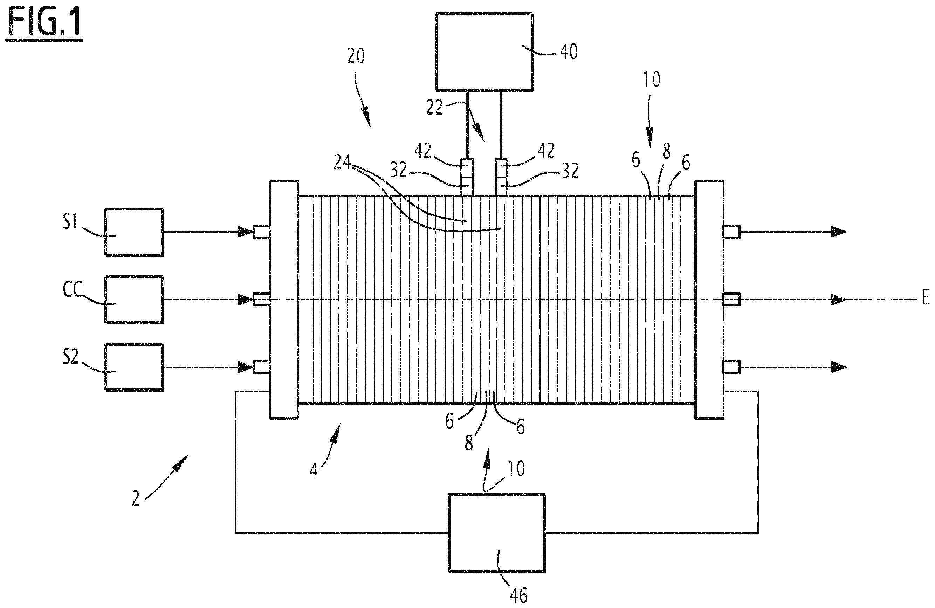

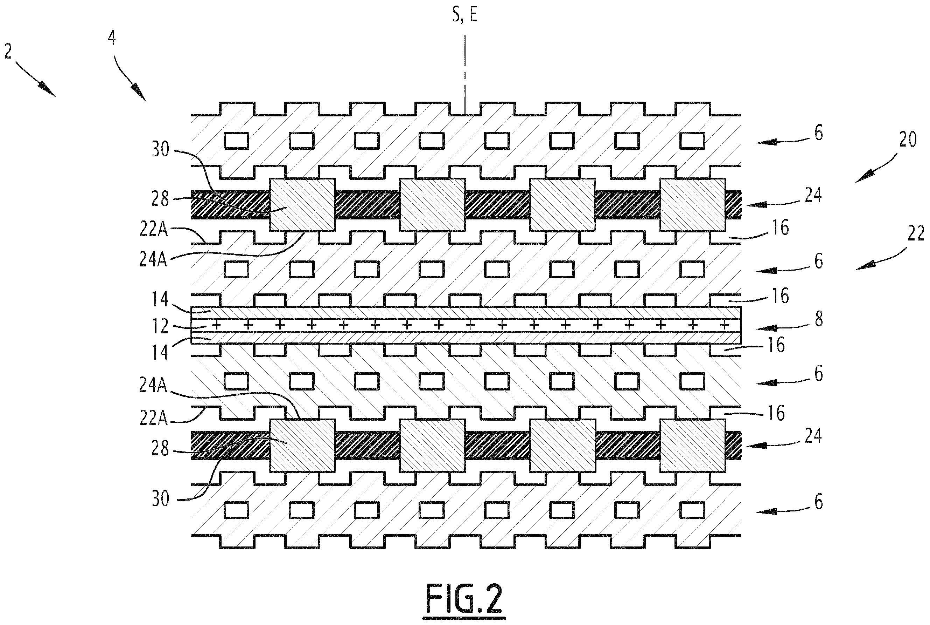

Le réacteur électrochimique 2 illustré sur les Figures 1 et 2 possède un empilement 4 (ou « stack ») de séparateurs 6 et d'assemblages membrane-électrodes 8 définissant une pluralité de cellules électrochimiques 10 superposées.

Les séparateurs 6 et les assemblages membrane-électrodes 8 sont empilés suivant une direction d'empilement E. Les cellules électrochimiques 10 sont superposées suivant la direction d'empilement E.

En pratique, un réacteur électrochimique 2 peut comprendre plusieurs dizaines ou centaines de cellules électrochimiques 10 superposées.

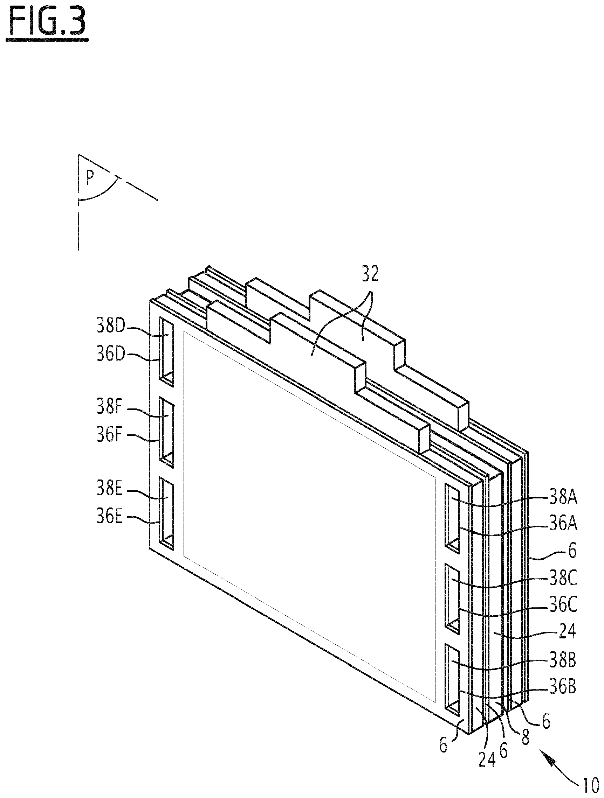

Comme illustré sur les Figures 2 et 3, chaque cellule électrochimique 10 de l'empilement 4 est formée par un assemblage membrane-électrodes 8 interposé entre deux séparateurs 6.

L'assemblage membrane-électrodes 8 (ou MEA de l'anglais « Membrane Electrodes Assembly ») se présente sous la forme d'un stratifié formé d'une membrane échangeuse d'ions 12 interposée entre deux électrodes 14 (Figure 2). La membrane échangeuse d'ions 12 est par exemple une membrane échangeuse de protons (ou PEM de l'anglais « Proton Exchange Membrane ») ou une membrane échangeuse d'anions (ou AEM de l'anglais « Anion Echange Membrane »).

Chaque séparateur 6 est conducteur d'électricité.

Chaque séparateur 6 est par exemple réalisé dans un matériau métallique ou, de préférence, dans un matériau contenant de la poudre de graphite et/ou de la poudre de carbone, par exemple un matériau composite comprenant de la poutre de graphite et/ou de la poudre de carbone dans une matrice réalisée dans un liant polymère et/ou une résine.

Chaque séparateur 6 se présente sous la forme d'une plaque. Chaque séparateur 6 possède deux faces opposées.

Chaque cellule électrochimique 10 s'étend suivant un plan d'extension P. Le plan d'extension P de chaque cellule électrochimique 10 est perpendiculaire à la direction d'empilement E suivant lequel les séparateurs 6 et l'assemblage membrane-électrodes 8 sont empilés.

Les séparateurs 6 et l'assemblage membrane-électrodes 8 s'étendent chacun suivant le plan d'extension P. Le plan d'extension P est sensiblement parallèle aux séparateurs 6 et à l'assemblage membrane-électrodes 8 de la cellule électrochimique 10.

Dans chaque cellule électrochimique 10, chaque séparateur 6 est appliqué contre une face respective de l'assemblage membrane-électrodes 8.

Chacun des deux séparateurs 6 de la cellule électrochimique 10 a sa face appliquée contre l'assemblage membrane-électrodes 8 qui est configurée pour canaliser un fluide le long de la face de l'assemblage membrane-électrodes 8 contre laquelle le séparateur 6 est appliqué.

La face du séparateur 6 appliquée contre l'assemblage membrane-électrodes 8 comprend par exemple des canaux de distribution 16 pour la circulation du fluide. Les canaux de distribution 16 définissent ensemble un champ d'écoulement de fluide (ou « Fluid Flow Field ou Gas Flow Field » selon la terminologie anglaise).

Lorsque la face du séparateur 6 est appliquée contre l'assemblage membrane-électrodes 8, le champ d'écoulement défini, avec l'assemblage membrane-électrodes 8, une chambre fluidique.

En fonctionnement, dans chaque cellule électrochimique 10, les fluides circulant le long des deux faces opposées de l'assemblage membrane-électrodes 8 permettent la réalisation d'une réaction électrochimique avec échange d'ions (ou d'anions) entre les fluides canalisés par les deux séparateurs 6 situés de part et d'autre de l'assemblage membrane-électrodes 8, les ions (ou les anions) passant à travers l'assemblage membrane-électrodes 8.

Dans chaque cellule électrochimique 10, la réaction électrochimique s'effectue à travers l'assemblage membrane-électrodes 8 sur une zone dite « surface active ». La surface active s'étend suivant le plan d'extension P. La surface active est la zone de l'assemblage membrane-électrodes 8 qui est située en regard des champs d'écoulement des séparateurs 6.

Si le réacteur électrochimique 2 est une pile à combustible, un des deux séparateurs 6 est configuré pour canaliser un fluide combustible le long de la face de l'assemblage membrane-électrodes 8 contre laquelle il est appliqué, l'autre séparateur 6 étant configuré pour canaliser un fluide comburant le long de l'autre face de l'assemblage membrane-électrodes 8 contre laquelle il est appliqué.

L'empilement 4 comprend par exemple des séparateurs 6 bipolaires (ou « Bipolar Plate » selon la terminologie anglaise), chaque séparateur 6 bipolaire étant interposé entre deux assemblages membrane-électrodes 8, chacune des deux faces du séparateur 6 étant configurée pour canaliser un fluide le long de la face de l'assemblage membrane-électrode 8 contre laquelle cette face du séparateur 6 est appliquée. Chaque séparateur 6 bipolaire est commun à deux cellules électrochimiques 10 adjacentes.

L'empilement 4 comprend par exemple des séparateurs 6 monopolaires, chaque séparateur 6 monopolaire ayant une seule de ses deux faces appliquée contre une face d'un assemblage membrane-électrodes 8, cette face du séparateur 6 étant configurée pour canaliser un fluide le long de ladite face de l'assemblage membrane-électrode 8. Chaque séparateur 6 monopolaire est appartient à une seule cellule électrochimique 10.

L'empilement 4 est par exemple formé de séparateurs 6 bipolaires empilés en alternance avec des assemblages membrane-électrodes 8, deux séparateurs 6 monopolaires étant disposés aux extrémités de l'empilement 4 pour définir les deux cellules électrochimiques 10 situées aux extrémités de l'empilement 4.

Dans chaque cellule électrochimique 10, les séparateurs 6 assurent la distribution des fluides et la conduction d'électricité.

Dans l'empilement 4, les cellules électrochimique 10 sont reliées électriquement en série, via les séparateurs 6. Chaque cellule électrochimique 10 est reliée électriquement à la cellule électrochimique 10 suivante.

En fonctionnement, chaque cellule électrochimique 10 présente une tension électrique, qui correspond à la différence de potentiel entre les deux séparateurs 6 de cette cellule électrochimique 10, et est traversée par un courant électrique.

La tension des cellules électrochimiques 10 peut varier d'une cellule électrochimique 10 à l'autre. Le courant électrique traversant les cellules électrochimiques 10 est en principe le même puisque les cellules électrochimiques 10 sont reliée électriquement en série.

Comme illustré sur les Figures 1 à 3, un dispositif de mesure de tension 20 est configuré pour mesurer la tension à travers une cellule électrochimique 10 ou plusieurs cellules électrochimiques 10 superposées.

Le dispositif de mesure de tension 20 est configuré pour mesurer une tension électrique à travers un ensemble stratifié 22 formé de séparateurs 6 et au moins un assemblage membrane-électrodes 8 empilés suivant une direction de stratification S et définissant une cellule électrochimique 10 ou plusieurs électrochimiques 10 superposées suivant la direction de stratification S, chaque cellule électrochimique 10 étant formée d'un assemblage membrane-électrodes 8 intercalé entre deux séparateurs 6.

L'ensemble stratifié 22 comprend, le long de la direction de stratification S, deux faces d'extrémité 22A opposées, chaque face d'extrémité 22A est définie par un séparateur 6 respectif de l'ensemble stratifié 22.

Le dispositif de mesure de tension 20 comprend deux plaques de mesure 24 configurées pour être disposées de part et d'autre de l'ensemble stratifié 22, l'ensemble stratifié 22 étant intercalé entre les deux plaques de mesure 24 suivant la direction de stratification S.

Chaque plaque de mesure 24 possède une face de mesure 24A prévue pour être mise en contact avec une face d'extrémité 22A respective de l'ensemble stratifié 22, i.e. avec un séparateur 6 respectif parmi les deux séparateurs 6 situés aux extrémités de l'ensemble stratifié 22.

Les plaques de mesure 24 du dispositif de mesure de tension 20 sont ici intégrées à l'empilement 4 du réacteur électrochimique 2 pour mesurer la tension d'une des cellules électrochimiques 10 de l'empilement 4.

L'ensemble stratifié 22 est constitué de deux séparateurs 6 entre lesquels est intercalé un assemblage membrane-électrode 8, les deux séparateurs 6 et l'assemblage membrane-électrodes 8 formant une cellule électrochimique 10. La direction de stratification S de l'ensemble stratifié 22 coïncide avec la direction d'empilement E de l'empilement 4.

Comme illustré sur les Figures 1 à 3, chacune des deux plaques de mesure 24 est insérée dans l'empilement 4, de préférence entre deux séparateurs 6.

Chaque plaque de mesure 24 est par exemple configurée pour être insérée dans l'empilement 4 entre deux séparateurs 6 bipolaires, en prenant la place d'un assemblage membrane-électrodes 8.

De préférence, chaque plaque de mesure 24 est prévue pour assurer la connexion électrique en série de deux séparateurs 6 entre lesquelles la plaque de mesure 24 est intercalée.

Ceci permet d'insérer la plaque de mesure 24 dans un empilement 4 entre deux séparateur 6, par exemple à la place d'un assemblage membrane-électrode 8, sans rompre la connexion électrique en série des cellules électrochimiques 10.

Chaque plaque de mesure 24 porte sur sa face de mesure 24A, une pluralité de contacts électriques 28 répartis sur la face de mesure 24A de la plaque de mesure 24 en étant espacés les uns des autres et isolés électriquement les uns des autres.

Les contacts électriques 28 de chaque plaque de mesure 24 sont disposés de telle manière que la plaque de mesure 24 appliquée contre la face d'extrémité 22A de l'ensemble stratifié 22 est en contact avec cette face d'extrémité 22A par l'intermédiaire des contacts électriques 28.

Chaque plaque de mesure 24 comprend par un exemple un substrat 30 en forme de plaque réalisé dans un matériau électriquement isolant, le substrat 30 portant les contacts électriques 28.

Chaque contact électrique 28 est réalisé dans un matériau conducteur d'électricité, par exemple dans un matériau métallique.

De préférence, les contacts électriques 28 de chaque plaque de mesure 24 sont répartis dans une zone de mesure de forme correspondante à celle de la surface active de l'assemblage membrane-électrodes 8 ou des assemblages membrane-électrodes 8 de l'ensemble stratifié 2 intercalé entre les deux plaques de mesure 24.

La zone de mesure de chaque plaque de mesure 24 recouvre en particulier le champ d'écoulement de chaque séparateur 6 de l'ensemble stratifié 2.

La zone de mesure de chaque plaque de mesure 24 présente par exemple une forme rectangulaire.

De préférence, les contacts électriques 28 de chaque plaque de mesure 24 sont répartis sur la face de mesure 24A de telle manière que chaque contact électrique 28 d'une plaque de mesure 24 est aligné avec un contact électrique 28 respectif associé de l'autre plaque de mesure 24 lorsque les faces de mesure 24A des plaques de mesure 24 sont disposées en regard l'une de l'autre.

Lorsque les plaques de mesure 24 sont disposées de part et d'autre d'un ensemble stratifié 22, chaque contact électrique 28 d'une plaque de mesure 24 est aligné avec un contact électrique 28 respectif associé de l'autre plaque de mesure 24 suivant la direction de stratification S.

Chaque contact électrique 28 d'une plaque de mesure 24 et le contact électrique 28 de l'autre plaque de mesure 24 définissent ensemble un point de mesure pour la mesure de la tension de l'ensemble stratifié 22 prise entre les deux séparateurs 6 en contact aux extrémités de l'ensemble stratifié 22.

Dans un exemple de réalisation, les contacts électriques 28 de chaque plaque de mesure 24 sont répartis sur la face de mesure 24A de la plaque de mesure 24 suivant une répartition matricielle. Une répartition matricielle désigne une répartition en lignes et colonnes.

Avantageusement, comme illustré sur la Figure 2, un ou plusieurs des contact(s) électrique(s) 28 de chaque plaque de mesure 24 traverse(nt) le substrat 30, de manière à connecter électriquement deux séparateurs 6 entre lesquels la plaque de mesure 24 est intercalée.

Ainsi, chaque plaque de mesure 24 peut assurer la connexion électrique en série des deux séparateurs 6 entre lesquelles la plaque de mesure 24 est intercalée.

Dans un exemple particulier, comme illustré sur la Figure 2, chaque contact électrique 28 de chaque plaque de mesure 24 traverse le substrat 30 de manière à connecter électriquement deux séparateurs 6 entre lesquels la plaque de mesure 24 est intercalée.

Chaque contact électrique 28 traversant la substrat 30 est par exemple saillant par rapport au substrat 30 sur la face de mesure 24A de la plaque de mesure 24 et sur la face opposée.

Avantageusement, chaque plaque de mesure 24 présente un contour externe sensiblement identique à celui des séparateurs 6. Ceci permet d'insérer facilement la plaque de mesure 24 dans un empilement 4 d'un réacteur électrochimique 2, par exemple entre deux séparateurs 6 de l'empilement 4, la plaque de mesure 24 étant alignée avec les séparateurs 6 sans déborder.

Chaque plaque de mesure 24 est par exemple munie d'un connecteur électrique 32 situé sur un bord de la plaque de mesure 24, chaque contact électrique 28 porté par la plaque de mesure 24 étant relié au connecteur électrique 32.

Le connecteur électrique 32 fait par exemple saillie du bord de la plaque de mesure 24. Ainsi, le connecteur électrique 32 peut faire saillie de l'empilement 4 du réacteur électrochimique 2 lorsque le dispositif de mesure 20 est intégré dans cet empilement 4, ce qui facilite la connexion de la plaque de mesure 24.

Le connecteur électrique 32 comprend des fiches électriques 34, chaque fiche électrique 34 étant reliée à un contact électrique 28 respectif, par exemple via une piste électrique (non représentée pour des raisons de clarté des dessins).

Comme visible sur la Figure 3, chaque séparateur 6 comprend des lumières 36A, 36B, 36C, 36D, 36E, 36F configurées pour former, à travers plusieurs séparateurs 6 empilés avec un ou plusieurs assemblage(s) membrane-électrodes 8, des conduits pour l'écoulement de fluides réactifs nécessaires à la réaction d'oxydoréduction, et optionnellement, pour l'écoulement d'un fluide de refroidissement.

Dans un empilement de séparateurs 6 et d'un ou plusieurs assemblages membrane-électrodes 8 définissant une ou plusieurs cellules électrochimiques 10, comme l'empilement 4 ou l'ensemble stratifié 22, les lumières 36A, 36B, 36C, 36D, 36E, 36F des séparateurs 6 sont alignées en définissant plusieurs conduits traversant l'empilement 4, chaque conduit permettant l'écoulement d'un fluide réactif ou d'un fluide de refroidissement. Chaque conduit est un conduit d'entrée située ou un conduit de sortie.

Les champs d'écoulement des séparateurs 6, et des éventuels conduits de refroidissement des séparateurs 6, sont reliés fluidiquement aux conduits définis par les lumières 36A, 36B, 36C, 36D, 36E, 36F, pour l'écoulement des fluides réactifs dans les champs d'écoulement, et l'écoulement d'un éventuel fluide de refroidissement dans les conduits de refroidissement.

Chaque séparateur 6 comprend par exemple une lumière 36A pour un conduit d'entrée d'un premier fluide réactif, une lumière 36B pour former un conduit d'entrée d'un deuxième fluide réactif, une lumière 36C pour former un conduit d'entrée d'un fluide de refroidissement, une lumière 36D pour former un conduit de sortie du premier fluide réactif, une lumière 36E pour former un conduit de sortie du deuxième fluide réactif, et une lumière 36F pour former un conduit de sortie du fluide de refroidissement.

De préférence, chaque plaque de mesure 24 comprend des fenêtres 38A, 38B, 38C, 38D, 38E, 38F disposées de telle manière à être alignées avec les lumières 36A, 36B, 36C, 36D, 36E, 36F d'un séparateur 6 contre lequel la plaque de mesure 24 est appliquée, chaque fenêtre 38A, 38B, 38C, 38D, 38E, 38F de plaque de mesure 24 étant alignée avec une lumière 36A, 36B, 36C, 36D, 36E, 36F respective du séparateur 6.

Ainsi, chaque plaque de mesure 24 peut être disposée sur un ensemble stratifiée 2 ou insérée dans l'empilement 4 en permettant l'écoulement de chaque fluide réactif et optionnellement d'un fluide de refroidissement à travers l'ensemble stratifié 22 et, le cas échéant, l'empilement 4.

En revenant à la Figure 1, les plaques de mesure 24 sont intégrées dans l'empilement 4 en étant située de part et d'autre d'un ensemble stratifié 22 correspondant à une cellule électrochimique 10, formé d'un assemblage membrane-électrode 8 intercalé entre deux séparateurs 6.

Chaque plaque de mesure 24 est insérée dans l'empilement 4 en étant intercalée entre deux séparateurs 6.

Seuls les connecteurs 32 des plaques de mesure 24 font saillie de l'empilement 4, plus particulièrement d'une face latérale 4A de l'empilement 4.

Dans l'empilement 4, les lumières 36A, 36B, 36C, 36D, 36E, 36F des séparateurs 6 sont alignées en définissant plusieurs conduits traversant l'empilement 4, chaque conduit permettant l'écoulement d'un fluide réactif ou d'un fluide de refroidissement. Chaque conduit est un conduit d'entrée située ou un conduit de sortie.

L'empilement 4 est relié fluidiquement à au moins une source de fluide réactif, ici deux sources de fluides réactifs S1, S2, et, optionnellement, à un circuit de refroidissement CC.

Chaque source de fluide réactif S1, S2 est par exemple relié à un conduit d'entrée définit par les lumières 36A, 36B. Le cas échéant, le circuit de refroidissement CC est par exemple relié à un conduit d'entrée définit par les lumières 36C. Chacun des conduits d'entrée débouche à une extrémité de l'empilement 4. Les conduits de sortie formés par les lumières 36D, 36E, 36F débouchent chacun à une extrémité de l'empilement 4.

Les plaques de mesure 24 sont intégrées dans l'empilement 4 avec chacune de leurs fenêtres 38A, 38B, 38C, 38D, 38E, 38F alignée suivant la direction d'empilement E avec la lumière 36A, 36B, 36C, 36D, 36E, 36F correspondante des séparateurs 6. Ainsi, les plaques de mesure 24 permettent l'écoulement des fluides à travers l'empilement 4.

Chaque plaque de mesure 24 assure une connexion électrique en série entre les deux séparateurs 6 entre lesquelles elle est interposée, pour assurer la connexion électrique en série de l'ensemble des cellules électrochimiques 10 de l'empilement 4.

Le dispositif de mesure de tension 20 comprend un appareil de mesure de tension multivoies 40 configuré, lorsqu'il est connecté aux plaques de mesure 24, pour mesurer la tension à travers l'ensemble stratifié 22 en chaque point de mesure défini par deux contacts électriques 28 associés des plaques de mesure 24.

Avantageusement, l'appareil de mesure de tension multivoies 40 est configuré pour établir une cartographie indiquant la tension au travers de l'ensemble stratifié 22 pour chaque point de mesure définit par les contacts électriques 28 associés des plaques de mesure 24.

Comme illustré sur la Figure 1, l'appareil de mesure de tension multivoies 40 est connecté aux plaques de mesure 24 par l'intermédiaire de connecteurs d'appareil 42 complémentaire de connecteurs de plaque 32, chaque connecteur d'appareil 42 étant connecté sur un connecteur de plaque 32 respectif.

L'appareil de mesure de tension multivoies 40 est par exemple configuré pour déterminer une cartographie de polarisation de l'ensemble stratifié 22 et en déduire une cartographie de polarisation d'une cellule électrochimique 10 de l'ensemble stratifié 22.

La cartographie de polarisation est la réponse en tension de l'ensemble stratifié 22 ou d'une cellule électrochimique 10 de l'ensemble stratifié 22 en fonction du courant traversant l'ensemble stratifié 22 ou la cellule électrochimique 10, pour les différents points de mesure définis par les contacts électriques 28 des plaques de mesure 24.

La cartographie de polarisation est déterminée par exemple en faisant fonctionner le réacteur électrochimique 2 en imposant le courant traversant l'empilement 4, et donc l'ensemble stratifié 22 et chaque cellule électrochimique 10, par exemple à l'aide d'une charge programmable 46 connectée aux bornes de l'empilement 4, et en mesurant la tension de l'ensemble stratifié 22 en chaque point de mesure défini par les contacts électriques 28 des plaques de mesure 24.

Lorsque l'ensemble stratifié 22 comprend une seule cellule électrochimique 10, la tension en chaque point de mesure peut être considérée comme égale à la tension en ce point de mesure de la cellule électrochimique 10.

Lorsque l'ensemble stratifié 22 comprend plusieurs cellules électrochimiques superposées, la tension en chaque point de mesure pour chaque cellule électrochimique 10 peut être considérée comme égale à la tension de l'ensemble stratifié 22 en ce point de mesure, divisée par le nombre cellules électrochimique 10 de l'ensemble stratifié 22.

Grâce au dispositif de mesure de tension 20, il est possible de mesurer la tension en différent points d'un ensemble stratifié 22 comprenant une ou plusieurs cellule(s) électrochimique(s), et de réaliser une cartographie de la tension de l'ensemble stratifié 22 pour les différents points de mesure.

Les points de mesure sont répartis sur une zone active des cellules électrochimiques 10. Il est ainsi possible de détecter des inhomogénéités de tension. De telles inhomogénéités peuvent apparaître par exemple avec des séparateurs 6 réalisés en matériau à base de carbone composite.

Les mesures peuvent être réalisées en intégrant le dispositif de mesure 20 dans un empilement 4 d'un réacteur électrochimique, en réalisant la mesure sur un ensemble stratifié 22 formé d'une ou plusieurs cellules électrochimiques 10 de l'empilement 4.

La mesure de tension peut ainsi être réalisée *in situ,* et ainsi prendre en compte des paramètres de performances de l'empilement 4, tel que l'état mécanique de compression de l'empilement 4 et/ou la liaison des séparateurs 6 et des assemblages membrane-électrodes 8 pour l'étanchéité de l'empilement 4.

La cartographie associée à ces mesures de tension permettra également d'avoir une image de l'hétérogénéité des propriétés de conduction électrique des séparateurs 6 qui peuvent induire une hétérogénéité de fonctionnement de l'empilement 4.

## Revendications

1. Dispositif de mesure de tension pour la réalisation de mesures de tension sur un ensemble stratifié (22) formé de séparateurs (6) et d'au moins un assemblage membrane-électrodes (8) empilés suivant une direction de stratification (S) pour former une cellule électrochimique (10) ou plusieurs cellules électrochimiques (10) superposées, un séparateur (6) étant situé à chaque extrémité de l'ensemble stratifié (22), le dispositif de mesure de tension comprenant deux plaques de mesure (24), chaque plaque de mesure possédant une face de mesure (24A) sur laquelle sont répartis une pluralité de contacts électriques (28) espacés les uns des autres et isolés électriquement les uns des autres, les plaques de mesure (24) étant configurées pour être disposées de part et d'autre de l'ensemble stratifié (22), la face de mesure de chaque plaque de mesure (24) étant appliquée contre un séparateur (6) respectif parmi les deux séparateurs (6) situés aux extrémités de l'ensemble stratifié (22), de telle sorte que les contacts électriques (28) situés sur cette face de mesure (24A) sont en contact avec ledit séparateur (6).

2. Dispositif de mesure de tension selon la revendication 1, dans lequel chaque plaque de mesure (24) possède un connecteur (32) situé sur un bord de la plaque, chaque contact électrique (28) porté par la plaque étant relié au connecteur (32).

3. Dispositif de mesure de tension selon la revendication 2, dans lequel le connecteur (32) de chaque plaque de mesure (24) comprend une pluralité de fiches (34), chaque fiche (34) étant reliée électriquement à un contact électrique (28) respectif parmi les contacts électriques (28) de la plaque de mesure (24).

4. Dispositif de mesure de tension selon l'une quelconque des revendications précédentes, dans lequel les contacts électriques (28) sont répartis sur la face de mesure (24A) de chaque plaque de mesure (24) de telle manière que chaque contact électrique d'une plaque de mesure (24) soit en regard d'un contact électrique (28) respectif de l'autre plaque de mesure (24) lorsque les faces de mesure (24A) des plaques de mesure (24) sont disposées en regard l'une de l'autre.

5. Dispositif de mesure de tension selon l'une quelconque des revendications précédentes, dans lequel chaque plaque de mesure (24) comprend un substrat (30) en forme de plaque réalisé dans un matériau électriquement isolant et portant les contacts électriques (28).

6. Dispositif de mesure de tension selon l'une quelconque des revendications précédentes, dans lequel les contacts électriques (28) de chaque plaque de mesure (24) sont répartis dans une zone de la face de mesure correspondant à la surface active de la ou des cellule(s) électrochimique(s) (10) de l'ensemble stratifié (22).

7. Dispositif de mesure de tension selon l'une quelconque des revendications précédentes, dans lequel les contacts électriques (28) de chaque plaque de mesure (24) sont répartis sur la face de mesure (24) de la plaque de mesure (24) suivant une répartition matricielle, en lignes et en colonnes.

8. Dispositif de mesure de tension selon l'une quelconque des revendications précédentes, comprenant un appareil de mesure de tension multivoies (40) configuré des déterminer des mesures de tension, une mesure de tension étant réalisée pour chaque point de mesure défini par un contact électrique (28) d'une des plaques de mesure (24) et un contact électrique (28) associé de l'autre plaque de mesure (24) situés sensiblement en regard l'un de l'autre.

9. Dispositif de mesure de tension selon l'une quelconque des revendications précédentes, dans lequel chaque plaque de mesure (24) comprend des fenêtres (38A, 38B ; 38C, 38D, 38E, 38F) disposées de telle manière à être alignées avec des lumières (36A, 36B, 36C, 36D, 36E, 36F) d'un séparateur (6) contre lequel la plaque de mesure (24) est appliquée, prévue pour l'écoulement de fluides réactif ou d'un fluide de refroidissement à travers le séparateur (6), chaque fenêtre (38A, 38B, 38C, 38D, 38E, 38F) de chaque plaque de mesure (24) étant alignée avec une lumière (36A, 36B, 36C, 36D, 36E, 36F) respective du séparateur (6).

10. Ensemble comprenant un ensemble stratifié (22) formé de séparateurs (6) et d'au moins un assemblage membrane-électrodes (8) empilés suivant une direction de stratification (S) pour former une cellule électrochimique (10) ou plusieurs cellules électrochimiques (10) superposées, un séparateur (6) étant situé à chaque extrémité de l'ensemble stratifié (22), et un dispositif de mesure de tension (20) selon l'une quelconque des revendications précédentes dont les plaques de mesure (24) sont disposées de part et d'autre de l'ensemble stratifié (22), la face de mesure (24A) de chaque plaque de mesure (24) étant appliquée contre un séparateur (6) respectif parmi les deux séparateurs (6) situés aux extrémités de l'ensemble stratifié (22), de telle sorte que les contacts électriques (28) situés sur cette face de mesure (24A) sont en contact avec ledit séparateur (6).

11. Ensemble selon la revendication 10, comprenant un réacteur électrochimique (2) comprenant un empilement (4) formé de séparateurs (6) et d'assemblages membrane-électrodes (8) empilés définissant des cellules électrochimiques (10) superposées, les plaques de mesure (24) étant intégrées dans l'empilement (4), de part et d'autre d'un ensemble stratifié (22) formé par des séparateurs et au moins un assemblage membrane-électrodes (8) de l'empilement (4) formant une ou plusieurs cellules électrochimiques (10) de l'empilement (4).
